# EUROPÄISCHE PATENTSCHRIFT

(11) **EP 2 715 939 B1**
(45) Veröffentlichungstag und Bekanntmachung des Hinweises auf die Patenterteilung: **14.01.2015**
(21) Anmeldenummer: 12713708.1
(22) Anmeldetag: 04.04.2012
(51) Int. Cl.: H03K 17/082, G01R 31/28

(54) **VERFAHREN UND VORRICHTUNG ZUM BETREIBEN EINER LEISTUNGSENDSTUFE**
METHOD AND APPARATUS FOR OPERATING A POWER OUTPUT STAGE
PROCÉDÉ ET DISPOSITIF D'EXPLOITATION D'UN ÉTAGE FINAL DE PUISSANCE

(30) Priorität: 26.05.2011 DE 102011076516
(43) Veröffentlichungstag der Anmeldung: 09.04.2014
(73) Patentinhaber: Robert Bosch GmbH, 70442 Stuttgart (DE)
(72) Erfinder: SCHWARZ, Albrecht, 71277 Rutesheim (DE)
(86) Internationale Anmeldenummer: PCT/EP2012/056148
(87) Internationale Veröffentlichungsnummer: WO 2012/159812

(56) Entgegenhaltungen:
- DE-A1- 3 430 409
- DE-A1- 19 600 807

## Beschreibung

Die Erfindung betrifft ein Verfahren zum Betreiben einer Leistungsendstufe, insbesondere einer elektrischen Maschine, die eine Brückenschaltung mit wenigstens einer Halbbrücke umfasst, wobei die Halbbrücke zwei in Reihe geschaltete Leistungshalbleiterschalter aufweist, die in einem Normalbetrieb mit einer Betriebs-Steuerspannung versorgt werden, um eine Leistungsspannung einzustellen, und wobei zur Kurzschlussüberwachung die Leistungsspannung des jeweiligen Leistungshalbleiterschalters erfasst wird.

Ferner betrifft die Erfindung eine Vorrichtung zum Betreiben einer Leistungsendstufe, insbesondere einer elektrischen Maschine, insbesondere zur Durchführung des oben stehenden Verfahrens, mit einer Brückenschaltung, die wenigstens eine Halbbrücke umfasst, wobei die Halbbrücke zwei in Reihe geschaltete Leistungshalbleiterschalter aufweist, die in einem Normalbetrieb mit einer Betriebs-Steuerspannung versorgt werden, um eine Leistungsspannung einzustellen, und mit einer Überwachungseinrichtung, die zur Kurzschlussüberwachung die Leistungsspannung des jeweiligen Leistungshalbleiterschalters erfasst.

### Stand der Technik

Verfahren und Vorrichtungen der eingangs genannten Art sind aus dem Stand der Technik bekannt. Bei Antriebsvorrichtungen für Kraftfahrzeuge, die einen elektrischen Antrieb umfassen, wie beispielsweise Hybridantriebsvorrichtungen oder Antriebsvorrichtungen für nur elektrisch angetriebene Fahrzeuge, sind üblicherweise Leistungsendstufen zum Ansteuern der jeweiligen elektrischen Maschine vorgesehen, die Leistungshalbleiterschalter, wie beispielsweise MOSFETs (Metall-Oxid-Halbleiter-Feldeffekttransistor) oder IGBTs

(Bipolartransistor mit isolierter Gate-Elektrode), sowie entsprechend zugeordnete Freilaufdioden umfassen. Zum Ansteuern von mehrphasigen, permanent und/oder fremderregten Elektromaschinen werden üblicherweise jeder Phase eine Halbbrücke der Leistungsendstufe zugeordnet. Die jeweilige Halbbrücke umfasst zwei in Reihe geschaltete Leistungshalbleiterschalter, die in einem Normalbetrieb mit einer Betriebs-Steuerspannung versorgt werden, um eine gewünschte Leistungsspannung einzustellen.

Zur Gewährleistung der Betriebssicherheit ist es darüber hinaus bekannt, die Leistungsspannung des jeweiligen Leistungshalbleiterschalters beziehungsweise an oder über den jeweiligen Leistungshalbleiterschalter zu überwachen, um eine Kurzschluss-Situation erfassen zu können. Wenn eine der Leistungshalbleiterschalter durch Ausfall in einen Kurzschluss geht, dann kann die Logik der Halbbrücke das Soll-Impulsmuster, das der elektrischen Maschine zur Momentenabgabe vorgegeben wird, nicht mehr aufrechterhalten. Insbesondere, wenn der zweite, dazu in Reihe geschaltete Leistungshalbleiterschalter trotz kurzgeschlossenem ersten Leistungshalbleiterschalter schaltet. In diesem Fall fließt ein in der Regel unzulässig hoher Strom, der im schlimmsten Fall zu Bränden im Leistungskreis führt, da die elektrische Energie, die durch die Leistungshalbleiterschalter in der Regel geschaltet wird, sehr hoch ist, und der Spannungsbereich so groß, dass Lichtbögen gegebenenfalls lange stehenbleiben. Vorzugsweise die Treiberschaltung der beiden Leistungshalbleiterschalter überwacht die jeweilige Leistungsspannung. Ist diese im eingeschalteten Zustand zu groß, wird angenommen, dass ein Überstrom fließt und die ganze Halbleiterbrücke in den Freilauf geschaltet wird, durch Abschalten beziehungsweise Deaktivieren der Leistungshalbleiterschalter. Dies ist auch als Entsättigungsüberwachung oder Dsat-Überwachung bekannt. Dabei wird die Eigenschaft der Leistungshalbleiterschalter ausgenutzt, dass sie bei zu großem Strom, dem sogenannten Entsättigungsstrom, einen überproportionalen Anstieg der Leistungsspannung bewirken. Die den Schaltern zur Verfügung gestellte Steuerspannung ist normalerweise so hoch, dass bei Betriebsströmen im Nennbereich der Halbbrücke beziehungsweise des Inverters möglichst kleine Spannungen abfallen, also deutlich unterhalb des Entsättigungsstroms, wodurch Schalt- und Durchlassverluste der Halbleiter verringert beziehungsweise minimiert werden.

Für die Sicherheit der Antriebsvorrichtung ist es nun essentiell, dass diese nur in Betrieb gehen soll, wenn gewährleistet ist, dass keine unkontrollierten Drehmomentänderungen auf den Antriebsstrang wirken, die das Fahrzeug außer Kontrolle geraten lassen können. Daher müssen sicherheitsrelevante, schlafende Fehler durch Test oder Redundanzen ausgeschlossen oder auf ein tolerables Restrisiko minimiert werden. Bei der Entsättigungsüberwachung ist dies problematisch, da die ordnungsgemäße Funktion nur dann erkannt werden kann, wenn der Kurzschlussfall künstlich herbeigeführt wird. Da der Kurzschlussstrom beziehungsweise Entsättigungsstrom in der Regel sehr viel höher als der Nennstrom im Normalbetrieb ist, würde ein künstlich herbeigeführter Kurzschluss ohne weitere Vorkehrungen die Lebensdauer der beteiligten elektrischen Komponenten verkürzen und gegebenenfalls zu einer unkontrollierten Drehmomentänderung führen.

Aus der Offenlegungsschrift DE 196 00 807 A1 ist beispielsweise bekannt, bei einer Leistungsendstufe mit einer Brückenschaltung, die wenigstens eine Halbbrücke mit zwei in Reihe gechalteten Leistungs-Halbleiterschaltern aufweist, in einem Normalbetrieb die Leistungs-Halbleiterschalter mit einer Betriebs-Steuerspannung zu versorgen. Zur Überwachung ist ein Überspannungsklemmen- und Entsättigungsdetektionsschaltkreis vorgesehen. Die Offenlegungsschrift DE 34 30 409 A1 schlägt vor, ein in sich abgeschlossenes transportables Prüfgerät vorzusehen, das zur Überwachung eines Hochspannungsnetzteils dient.

### Offenbarung der Erfindung

Das erfindungsgemäße Verfahren sieht daher vor, dass zum Prüfen der Funktion der Kurzschlussüberwachung in einem Prüfbetrieb für die beiden Leistungshalbleiterschalter der Halbbrücke zumindest zeitweise gleichzeitig eine Test-Steuerspannung eingestellt wird, die unterhalb der Betriebs-Steuerspannung liegt. Die Leistungshalbleiterschalter werden somit bevorzugt mit einer Spannungsversorgung gespeist, die auf einen Wert abgesenkt ist, bei dem die Spannungsüberwachung der Schalter-Treiber noch nicht anspricht. Dadurch, dass die beiden Leistungshalbleiterschalter der einen Halbbrücke zumindest zeitweise gleichzeitig mit der Test-Steuerspannung versorgt werden, wird ein Kurzschluss der Halbbrücke simuliert. Da darüber hinaus die Test-Steuerspannung unterhalb der Betriebs-Steuerspannung liegt, fällt der dabei erzeugte Kurzschlussstrom niedriger aus, als wenn die Betriebs-Steuerspannung anliegen würde. Die Leistungshalbleiterschalter beginnen innerhalb kürzerer Zeit zu entsättigen, wodurch die Kurzschlussüberwachung schnell anspricht und den Kurzschluss beseitigt. Der während des Kurzschlusses fließende Strom ist in diesem Fall durch die Wahl der Test-Steuerspannung vorzugsweise derart niedrig eingestellt, dass der dadurch erzeugte Momentenimpuls an der elektrischen Maschine so klein ist, dass er insbesondere durch das Massenträgheitsmoment eines Läufers der elektrischen Maschine sicher wegintegriert beziehungsweise gedämpft wird, sodass kein unzulässiges Moment in den Antriebsstrang des Fahrzeugs gelangt. Die Prüfung der Funktion der Kurzschlussüberwachung wird vorzugsweise durchgeführt, wenn die elektrische Maschine nicht in Betrieb genommen ist beziehungsweise kein Drehmoment erbringen soll.

Vorzugsweise wird zunächst einer der Leistungshalbleiterschalter mit der Test-Steuerspannung versorgt und anschließend der andere Leistungshalbleiterschalter. Dabei bleibt die Versorgung des einen Leistungshalbleiterschalters mit der Test-Steuerspannung zweckmäßigerweise so lange erhalten, bis der andere Leistungshalbleiterschalter zumindest zeitweise gleichzeitig mit der Test-Steuerspannung versorgt wurde, da durch das gleichzeitige Vorliegen der Test-Steuerspannung der Kurzschluss simuliert wird. Zweckmäßigerweise wird die Spannungsüberwachung an beiden Leistungshalbleiterschaltern gleichzeitig oder zunächst nur für einen und anschließend für den anderen der beiden Leistungshalbleiterschalter durchgeführt.

Besonders bevorzugt werden als Leistungshalbleiterschalter Metall-Oxid-Halbleiter-Feldeffekttransistoren (MOSFETs) oder Bipolartransistoren mit isolierter Gate-Elektrode (IGBTs) verwendet. Bevorzugt werden die Betriebs-Steuerspannung als Betriebs-Gatespannung und die Test-Steuerspannung als Test-Gatespannung vorgegeben, um eine Drain-Source-Spannung als Leistungsspannung einzustellen. Bei der Steuer-Spannung handelt es sich somit zweckmäßigerweise um eine Gate-Spannung des jeweiligen Leistungshalbleiterschalters.

Vorzugsweise wird die Test-Gatespannung derart gewählt, dass die Leistungshalbleiterschalter bei Strömen wenig oberhalb eines Nennstroms entsättigen. Bei dem Nennstrom handelt es sich dabei um den Strom, der durch die angelegte Test-Gatespannung eigentlich eingestellt werden würde, wenn kein Kurzschluss bestünde. Dadurch, dass die Test-Gatespannung wie oben beschrieben gewählt wurde, wird erreicht, dass die Kurzschlussüberwachung schnell anspringt und die fließenden Ströme für die elektrischen Komponenten ungefährlich sind.

Besonders bevorzugt wird die Einschaltzeit der Leistungshalbleiterschalter derart gewählt, dass der fließende Strom unterhalb des 2,5-fachen Nennstroms bleibt. Die Leistungshalbleiterschalter beginnen dann - Standard-Bauteile vorausgesetzt - spätestens im Bereich nach 1 µs zu entsättigen. Das heißt, die Kurzschlussüberwachung ist vorzugsweise so eingestellt, dass sie wenig später anspricht und den Kurzschluss beseitigt. Nach etwa 5 µs ist die Prüfung beziehungsweise der Test zu Ende, insbesondere wenn Stand der Technik-Bauelemente verwendet werden.

Weiterhin ist vorgesehen, dass die elektrische Maschine während der Prüfung im Stillstand durch bevorzugt einen Inverter in einen sicheren Zustand geschaltet wird. Zweckmäßigerweise handelt es sich bei dem Inverter um einen die Halbbrücke aufweisenden Inverter. Dabei kann die Ansteuerung des Inverters je nach Maschinentyp angepasst werden.

Während der Prüfung wird bevorzugt zur Erhöhung der Sicherheit eine Energiequelle über einen Vorladewiderstand an die Halbbrücke angeschlossen. Bei der Energiequelle handelt es sich beispielsweise um eine Traktionsbatterie oder einen anderen Energiespeicher. Durch den Anschluss über den Vorladewiderstand wird verhindert, dass über längere Zeit große Ströme in dem Inverter beziehungsweise in der Halbbrücke fließen können. Der Vorladewiderstand dient dazu, dass der Ladestrom eines Zwischenkreiskondensators der Leistungsendstufe beim Anlegen einer Betriebsspannung keine zu hohen Werte annimmt und es wegen des systembedingt niederinduktiven Aufbaus nicht zu Oszillationen der Drain-Spannung kommt.

Die erfindungsgemäße Vorrichtung zeichnet sich dadurch aus, dass zur Prüfung der Funktion der Überwachungseinrichtung in einem Prüfbetrieb für die Leistungshalbleiterschalter zumindest zeitweise gleichzeitig eine Test-Steuerspannung eingestellt wird, die unterhalb der Betriebs-Steuerspannung liegt. Bevorzugt wird die Prüfung von einer dem jeweiligen Leistungshalbleiterschalter zugeordneten Treiberschaltung durchgeführt. Weitere Ausführungsformen ergeben sich aus den Ansprüchen und den obenstehenden Ausführungen.

Im Folgenden soll die Erfindung anhand eines Ausführungsbeispiels näher erläutert werden. Dazu zeigt die einzige

Figur eine Halbbrücke in einer vereinfachten Darstellung.

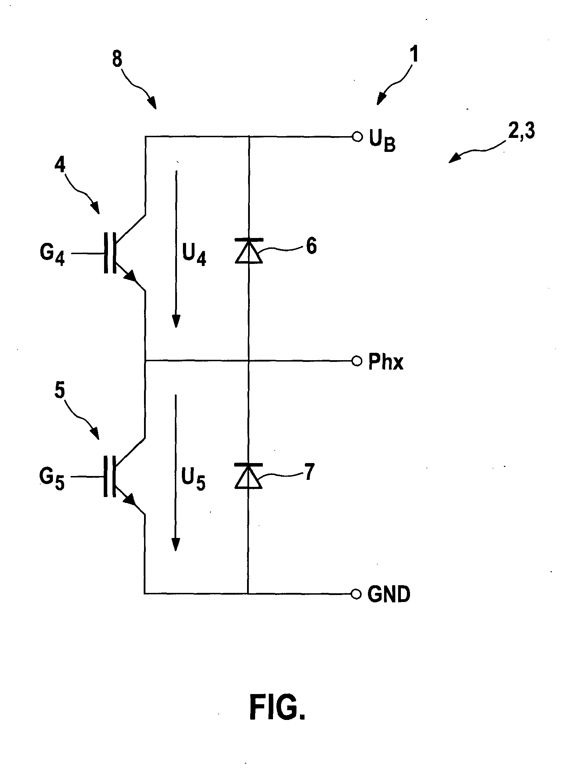

Die Figur zeigt eine Halbbrücke 1 einer hier nicht näher dargestellte Leistungsendstufe 2 einer Antriebsvorrichtung, die als Antriebsaggregat zumindest eine Elektromaschine umfasst, welche durch die Leistungsendstufe 2, genauer gesagt durch eine die Halbbrücke 1 aufweisende Brückenschaltung 3, angesteuert wird. Zweckmäßigerweise umfasst die Brückenschaltung 3 mehrere derartiger Halbbrücken 1, die jeweils einer Phase der Elektromaschine zugeordnet sind. Die Halbbrücke 1 weist zwei in Reihe geschaltete Leistungshalbleiterschalter 4 und 5 auf, die vorzugsweise jeweils als MOSFET oder IGBT-Schalterelement ausgebildet sind. Jedem der Leistungshalbleiterschalter 4,5 ist eine Freilaufdiode 6 beziehungsweise 7 auf die übliche Art und Weise zugeordnet. Die Halbbrücke 1 ist einer bestimmten Phase beziehungsweise einem Strang der oben erwähnten elektrischen Maschine zugeordnet, wobei der Strang an dem Anschluss Phx anliegt, der zwischen dem Source-Anschluss des Leistungshalbleiterschalters 4 und dem Drain-Anschluss des Leistungshalbleiterschalters 5 sowie zwischen den Freilaufdioden 6 und 7 geschaltet ist. Versorgt wird die Halbbrücke 1 durch eine entsprechende Betriebsspannung U_{B}, die an dem Drain-Anschluss des Leistungshalbleiterschalters 4 anliegt, während der Source-Anschluss des Leistungshalbleiterschalters 5 mit Masse GND verbunden ist. Die übrigen in einem Inverter vorhandenen Schaltelemente sind aus Übersichtlichkeitsgründen nicht dargestellt. Die Halbbrücke 1 bildet als Teil der Brückenschaltung 3 einen Bestandteil eines hier nicht weiter dargestellten Inverters 8, der die Impulsmuster für die elektrische Maschine erzeugt.

Die Leistungshalbleiterschalter 4 und 5 werden durch jeweils eine vorgebbare Gatespannung G₄ beziehungsweise G₅ als Steuerspannung betrieben beziehungsweise angesteuert. Hierdurch wird die Logik des Pulsmusters der Halbbrücke 1 beziehungsweise des Inverters 8 entsprechend vorgegeben. Die Halbbrücke 1 gerät in einen kritischen Zustand, wenn eines der Elemente der Schaltung, insbesondere einer der Leistungshalbleiterschalter 4,5 durch Ausfall in den Kurzschluss geht. Angenommen der Leistungshalbleiterschalter 4 fällt aus, dann liegt das Potenzial U_{B} ständig an dem Strang der Elektromaschine beziehungsweise an Phx an. Die Logik des Inverters 8 kann nun das Soll-Impulsmuster, das die Elektromaschine zur Momentenabgabe bringt, nicht mehr aufrechterhalten. Insbesondere, wenn die Treiberschaltung trotz kurzgeschlossenem Leistungshalbleiterschalter 4 (high side) den Leistungshalbleiterschalter 5 (low side) einschaltet. In diesem Fall fließt ein in der Regel unzulässig hoher Strom von U_{B} zu GND. Im schlimmsten Fall kann es zu Bränden im Leistungskreis kommen, da die elektrische Energie, die an U_{B} zur Verfügung steht, sehr hoch ist, und der Spannungsbereich so groß, dass Lichtbögen gegebenenfalls lange stehenbleiben, also deren Brennspannung kleiner als U_{B} ist. Um dies zu vermeiden, überwacht die hier nicht näher dargestellte Treiberschaltung der beiden Leistungshalbleiterschalter 4,5 die Drain-Source-Spannungen U₄ beziehungsweise U₅ als die jeweilige Leistungsspannung. Sind diese im eingeschalteten Zustand zu groß, wird ein Überstrom beziehungsweise ein Entsättigungsstrom angenommen und die ganze Halbbrücke 1 in den Freilauf geschaltet. Diese sogenannte Entsättigungsüberwachung nutzt die Eigenschaft der Leistungshalbleiterschalter 4,5 aus, die bei zu großem Sättigungsstrom einen überproportionalen Anstieg der Spannungen U₄, U₅ aufweisen. Zum Betreiben der Halbbrücke 1 wird den Leistungshalbleiterschaltern 4,5 im Normalbetrieb bevorzugt jeweils eine Gatespannung zur Verfügung gestellt, die derart hoch ist, dass bei Betriebsströmen im Nennbereich des Inverters 8 möglichst sehr kleine Spannungen abfallen, also deutlich unterhalb des Entsättigungsbereichs, zur Minimierung von Schalt- und Durchlassverlusten der Halbleiterelemente.

Zur Gewährleistung der Sicherheit ist eine Überwachungseinrichtung vorgesehen ist, die die Leistungshalbleiterschalter 4,5 auf Kurzschluss überwacht. Um die Sicherheit im Betrieb gewährleisten zu können, wird bevorzugt die Kurzschlussüberwachung beim Stillstand der elektrischen Maschine auf ihre Funktionsfähigkeit geprüft, sodass gewährleistet werden kann, dass, wenn tatsächlich ein Kurzschluss aufgrund eines Ausfalls auftritt, dieser erkannt und durch die Kurzschlussüberwachungseinrichtung durch Abschalten der Leistungshalbleiterschalter behoben werden kann.

Die hier nicht näher dargestellte Überwachungseinrichtung, die vorzugsweise in die Treiberschaltung integriert ist, versorgt zum Prüfen der

Kurzschlussüberwachung die Leistungshalbleiterschalter 4,5 zumindest zeitweise gleichzeitig mit einer Test-Gatespannung, die unterhalb der Betriebs-Gatespannung liegt. Gemäß dem vorliegenden Ausführungsbeispiel werden die Gate-Testspannungen auf einen Wert gesenkt, bei dem die Spannungsüberwachung der Treiberschaltung noch nicht anspricht. Die Werte werden dabei derart niedrig gewählt, dass die Leistungshalbleiterschalter 4,5 schon bei Strömen wenig oberhalb, das heißt je nach Anwendungsfall, beispielsweise ab dem zweifachen Nennstrom, entsättigen. Vorzugsweise werden die Leistungshalbleiterschalter 4,5 nacheinander in einen Kurzschluss geschaltet, indem zunächst der eine und dann der andere Leistungshalbleiterschalter mit der Test-Gatespannung versorgt wird. Dabei wird die Einschaltzeit der Leistungshalbleiterschalter 4,5 derart gewählt, dass der Strom unterhalb des 2,5-fachen Nennstroms bleiben würde. Übliche Halbleiterelemente beginnen dann etwa eine Mikrosekunde (1µs) später zu entsättigen. Das heißt, die Entsättigungsüberwachung ist derart eingestellt, dass sie wenig später anspricht und den Kurzschluss beseitigt. Nach spätestens fünf Mikrosekunden (5 µs) ist die Prüfung dann zu Ende, sofern Standard-Bauelemente genutzt werden. Die elektrische Maschine des Antriebs ist während der Prüfung vorzugsweise im Stillstand und wird durch den Inverter 8 in einen sicheren Zustand geschaltet. Der während der Prüfung entstehende Momentenimpuls ist derart klein, dass er durch das Massenträgheitsmoment des Läufers der elektrischen Maschine sicher gedämpft beziehungsweise wegintegriert wird und so kein unzulässiges Moment in den Triebstrang des Fahrzeugs gelangt. Vorzugsweise ist die während der Prüfung aller Phasen aus dem Zwischenkreis entnommene Energie je nach Anwendung bis auf 1 Ws oder zumindest auf einen Wert kleiner als 1 Ws, insbesondere kleiner als 3 Ws, begrenzt.

Vorzugsweise wird zumindest während der Prüfung zur Erhöhung der Sicherheit eine Traktionsbatterie über einen Vorladewiderstand an die Halbbrücke 1 angeschlossen, sodass sie die Betriebsspannung U_{B} bereitstellt. Auch kann ein anderer Energielieferant beziehungsweise eine andere Energiequelle über den Vorladewiderstand angeschlossen werden. Hierdurch wird erreicht, dass über längere Zeit keine großen Ströme in dem Inverter 8 fließen. Darüber hinaus ist bevorzugt, dass die Vorladung unterbrochen wird, sobald im Zwischenkreis des Inverters Spannungen zwischen 20 Volt und 80 Volt, insbesondere zwischen 30 Volt und 65 Volt, erreicht werden. Diese Spannungen reichen aus, um die oben beschriebene Prüfung der Kurzschlussüberwachung durchzuführen. Auf diese Art und Weise wird die Belastung der einzelnen Bauelemente weiter reduziert.

Das oben beschriebene Verfahren ermöglicht somit eine Prüfung einer Kurzschlussüberwachung, ohne dass hohe Kurzschlussströme erzeugt werden, die zu einer Beschädigung von elektrischen Komponenten führen könnten. Es werden keine gefährlichen, insbesondere unkontrollierten Drehmomente, in den Triebstrang eines die Leistungsendstufe 2 aufweisenden Kraftfahrzeugs eingeleitet. Die Leistungsendstufe 2 weist zweckmäßigerweise mehrere derartige Halbbrücken auf, um die Brückenschaltung 3 zu bilden. Aus Übersichtlichkeitsgründen wird im Folgenden nur Bezug auf eine dieser Halbbrücken Bezug genommen, wobei sich die Halbbrücken gleichen. Durch das oben beschriebene Verfahren ist es möglich, vor Inbetriebnahme der elektrischen Maschine einen eventuell schlafenden Fehler zu entdecken. Dabei sind keine kostenintensive Redundanz von den Schalterelementen erforderlich. Darüber hinaus lässt sich das oben beschriebene Verfahren auch bei bereits bestehenden beziehungsweise existierenden Invertern mit relativ geringem Aufwand nachrüsten.

## Patentansprüche

1. Verfahren zum Betreiben einer Leistungsendstufe (2), insbesondere einer elektrischen Maschine, die eine Brückenschaltung (3) mit wenigstens einer Halbbrücke (1) umfasst, wobei die Halbbrücke (1) zwei in Reihe geschaltete Leistungshalbleiterschalter (4,5) aufweist, die in einem Normalbetrieb jeweils mit einer Betriebs-Steuerspannung versorgt werden, um eine Leistungsspannung einzustellen, und wobei zur Kurzschlussüberwachung die Leistungsspannung (U₄,U₅) des jeweiligen Leistungshalbleiterschalters (4,5) erfasst wird, **dadurch gekennzeichnet, dass** in einem Prüfbetrieb zum Prüfen der Funktion der Kurzschlussüberwachung für die beiden Leistungshalbleiterschalter (4,5) zumindest zeitweise gleichzeitig eine unterhalb der Betriebs-Steuerspannung liegende Test-Steuerspannung eingestellt wird.

2. Verfahren nach Anspruch 1, **dadurch gekennzeichnet, dass** zunächst einer der Leistungshalbleiterschalter (4,5) mit der Test-Steuerspannung und anschließend der andere Leistungshalbleiterschalter (5,4) mit der Test-Steuerspannung versorgt wird.

3. Verfahren nach einem der vorhergehenden Ansprüche, **dadurch gekennzeichnet, dass** als Leistungshalbleiterschalter (4,5) Metall-Oxid-Halbleiter-Feldeffekttransistoren oder Bipolartransistoren mit isolierter Gate-Elektrode verwendet werden.

4. Verfahren nach einem der vorhergehenden Ansprüche, **dadurch gekennzeichnet, dass** die Betriebs-Steuerspannung eine Betriebs-Gatespannung, die Test-Steuerspannung eine Test-Gatespannung und die Leistungsspannung eine Drain-Source-Spannung (U₄,U₅) ist.

5. Verfahren nach einem der vorhergehenden Ansprüche, **dadurch gekennzeichnet, dass** die Test-Gatespannung derart gewählt wird, dass die Leistungshalbleiterschalter (4,5) bei Strömen wenig oberhalb eines Nennstroms entsättigen.

6. Verfahren nach einem der vorhergehenden Ansprüche, **dadurch gekennzeichnet, dass** die Einschaltzeit der Leistungshalbleiterschalter (4,5) derart gewählt wird, dass der fließende Strom unterhalb des 2,5-fachen Nennstroms bleibt.

7. Verfahren nach einem der vorhergehenden Ansprüche, **dadurch gekennzeichnet, dass** während der Prüfung die elektrische Maschine im Stillstand durch einen Inverter (8) in einen sicheren Zustand geschaltet wird.

8. Verfahren nach einem der vorhergehenden Ansprüche, **dadurch gekennzeichnet, dass** während der Prüfung eine Energiequelle über einen Vorladewiderstand an die Halbbrücke (1) angeschlossen wird.

9. Vorrichtung zum Betreiben einer Leistungsendstufe (2), insbesondere einer elektrischen Maschine, insbesondere zur Durchführung des Verfahrens nach einem oder mehreren der vorhergehenden Ansprüche, mit einer Brückenschaltung (3), die wenigstens eine Halbbrücke (1) umfasst, wobei die Halbbrücke (1) zwei in Reihe geschaltete Leistungshalbleiterschalter (4,5) aufweist, die in einem Normalbetrieb mit einer Betriebs-Steuerspannung versorgt werden, um eine Leistungsspannung einzustellen, und mit einer Überwachungseinrichtung, die zur Kurzschlussüberwachung die Leistungsspannung (U₄,U₅) des jeweiligen Leistungshalbleiterschalters (4,5) erfasst, **dadurch gekennzeichnet, dass** die Überwachungseinrichtung dazu ausgebildet ist, in einem Prüfbetrieb zur Prüfung der Funktion der Überwachungseinrichtung für die beiden Leistungshalbleiterschalter (4,5) zumindest zeitweise gleichzeitig eine unterhalb der Betriebs-Steuerspannung liegendeTest-Steuerspannung einzustellen.

## Claims

1. Method for the operation of a power output stage (2), in particular of an electrical machine, which comprises a bridge circuit (3) having at least one half-bridge (1), wherein the half-bridge (1) has two series-connected power semiconductor switches (4, 5) which, in a normal operating mode, are each supplied with an operating control voltage in order to set a power voltage, and wherein the power voltage (U₄, U₅) of the respective power semiconductor switch (4, 5) is detected for the purpose of short-circuit monitoring, **characterized in that**, in order to check the function of the short-circuit monitoring in a check mode for the two power semiconductor switches (4, 5), a test control voltage, which is below the operating control voltage, is at least intermittently set simultaneously.

2. Method according to Claim 1, **characterized in that** firstly one of the power semiconductor switches (4, 5) is supplied with the test control voltage and subsequently the other power semiconductor switch (5, 4) is supplied with the test control voltage.

3. Method according to one of the preceding claims, **characterized in that** metal-oxide semiconductor field-effect transistors or insulated-gate bipolar transistors are used as power semiconductor switches (4, 5).

4. Method according to one of the preceding claims, **characterized in that** the operating control voltage is an operating gate voltage, the test control voltage is a test gate voltage and the power voltage is a drain-source voltage (U₄, U₅).

5. Method according to one of the preceding claims, **characterized in that** the test gate voltage is selected such that the power semiconductor switches (4, 5) desaturate at currents slightly above a nominal current.

6. Method according to one of the preceding claims, **characterized in that** the switch-on time of the power semiconductor switches (4, 5) is selected such that the flowing current remains below 2.5 times the nominal current.

7. Method according to one of the preceding claims, **characterized in that**, during the check, the electrical machine at standstill is switched into a safe state by means of an inverter (8).

8. Method according to one of the preceding claims, **characterized in that**, during the check, an energy source is connected to the half-bridge (1) via a precharging resistor.

9. Apparatus for the operation of a power output stage (2), in particular of an electrical machine, in particular for performing the method according to one or more of the preceding claims, having a bridge circuit (3) which comprises at least one half-bridge (1), wherein the half-bridge (1) has two series-connected power semiconductor switches (4, 5) which, in a normal operating mode, are supplied with an operating control voltage in order to set a power voltage, and having a monitoring device which detects the power voltage (U₄, U₅) of the respective power semiconductor switch (4, 5) for the purpose of short-circuit monitoring, **characterized in that** the monitoring device is designed to simultaneously at least intermittently set a test control voltage, which is below the operating control voltage, in order to check the function of the monitoring device in a check mode for the two power semiconductor switches (4, 5).

## Revendications

1. Procédé pour faire fonctionner un étage final de puissance (2), notamment d'une machine électrique, lequel comprend un circuit en pont (3) comprenant au moins un demi-pont (1), le demi-pont (1) présentant deux commutateurs semiconducteurs de puissance (4, 5) branchés en série qui, dans un fonctionnement normal, sont respectivement alimentés en une tension de commande de service afin d'établir une tension de puissance, et la tension de puissance (U₄, U₅) du commutateur semiconducteur de puissance (4, 5) respectif étant détectée en vue de la surveillance des courts-circuits, **caractérisé en ce que** dans un mode de contrôle, en vue de contrôler le fonctionnement de la surveillance des courts-circuits pour les deux commutateurs semiconducteurs de puissance (4, 5), une tension de commande de test inférieure à la tension de commande de service est établie simultanément au moins temporairement.

2. Procédé selon la revendication 1, **caractérisé en ce qu'**un des commutateurs semiconducteurs de puissance (4, 5) est tout d'abord alimenté avec la tension de commande de test et ensuite l'autre commutateur semiconducteur de puissance (5, 4) est alimenté avec la tension de commande de test.

3. Procédé selon l'une des revendications précédentes, **caractérisé en ce que** les commutateurs semiconducteurs de puissance (4, 5) utilisés sont des transistors à effet de champ semiconducteurs à métal-oxyde ou des transistors bipolaires à électrode de gâchette isolée.

4. Procédé selon l'une des revendications précédentes, **caractérisé en ce que** la tension de commande de service est une tension de gâchette de service, la tension de commande de test est une tension de gâchette de test et la tension de puissance est une tension drain-source (U₄, U₅).

5. Procédé selon l'une des revendications précédentes, **caractérisé en ce que** la tension de gâchette de test est choisie de telle sorte que les commutateurs semiconducteurs de puissance (4, 5), lorsqu'ils sont traversés par un courant, saturent moins au-dessus d'un courant nominal.

6. Procédé selon l'une des revendications précédentes, **caractérisé en ce que** la durée de fonctionnement des commutateurs semiconducteurs de puissance (4, 5) est choisie de telle sorte que le courant qui circule reste inférieur à 2,5 fois le courant nominal.

7. Procédé selon l'une des revendications précédentes, **caractérisé en ce que** pendant le contrôle, la machine électrique à l'arrêt est commutée dans un état sécurisé par un onduleur (8).

8. Procédé selon l'une des revendications précédentes, **caractérisé en ce que** pendant le contrôle, une source d'énergie est raccordée au demi-pont (1) par le biais d'une résistance de précharge.

9. Dispositif pour faire fonctionner un étage final de puissance (2), notamment d'une machine électrique, notamment pour mettre en oeuvre le procédé selon une ou plusieurs des revendications précédentes, comprenant un circuit en pont (3) qui comprend au moins un demi-pont (1), le demi-pont (1) présentant deux commutateurs semiconducteurs de puissance (4, 5) branchés en série qui, dans un fonctionnement normal, sont alimentés en une tension de commande de service afin d'établir une tension de puissance, et comprenant un dispositif de surveillance qui, en vue de la surveillance des courts-circuits, détecte la tension de puissance (U₄, U₅) du commutateur semiconducteur de puissance (4, 5) respectif, **caractérisé en ce que** le dispositif de surveillance est configuré pour, dans un mode de contrôle, en vue de contrôler le fonctionnement du dispositif de surveillance pour les deux commutateurs semiconducteurs de puissance (4, 5), établir simultanément une tension de commande de test inférieure à la tension de commande de service au moins temporairement.
